# EUROPEAN PATENT APPLICATION

(11) **EP 4 848 971 A1**
(43) Date of publication of application: **02.12.2026**
(21) Application number: 26179589.2
(22) Date of filing: 19.05.2026
(51) Int. Cl.: H10W 70/20, H10W 90/26, H05K 3/341, H10W 40/20, H10W 40/25, H10W 90/20

(54) **SURFACE MOUNTED DEVICE PACKAGE HAVING METALLIC HOUSING**

(30) Priority: 26.05.2025 CN 202510690242
(71) Applicant: Littelfuse Semiconductor (Wuxi) Co., Ltd., Wuxi, Jiangsu 214142 (CN)
(72) Inventor: Wang, Efferd, Wuxi, 214142 (CN); Shi, Lei, Wuxi, 214142 (CN)
(74) Representative: Arnold & Siedsma

(57) **Abstract**

A semiconductor package for a surface mounted device. The semiconductor package may include a metallic housing that has a main portion having a closed side and an open side, where a rim is disposed on the open side. The semiconductor package may further include a semiconductor die, disposed within the housing, wherein a first main surface of the semiconductor die is electrically coupled to the closed side of the metallic housing. The semiconductor package may also include an outer insert, disposed opposite the second main surface of the semiconductor die, wherein the outer insert and the rim are arranged in a coplanar fashion.

## Description

### Background

### Field

The disclosure relates to the field of semiconductor devices, and in particular, packages for power semiconductor chips.

### Discussion of Related Art

Semiconductor device packages (or simply, "semiconductor packages") such as power modules or discrete packages may include components such as semiconductor die (chips), substrates, and connectors, where the latter may include wires, clips, and other connectors. In particular, in power semiconductor packages, power chips may be included such as thyristors, field effect transistors (FETs), insulated gate bipolar transistors (IGBTs), and auxiliary chips, including diodes. A main purpose of clips is to electrically connect these chips to one another or to substrates.

In some known packages, such as for surface mounted devices, external leads are attached to a semiconductor die. For example, in an overvoltage protection device, a first lead may be connected to the semiconductor die on a first main surface to connect to a first device terminal, such as an anode, while a second lead is attached to the semiconductor die on a second main surface to attach to a second terminal, such as a cathode. The assembly of leads together with semiconductor die may be encapsulated in a housing that may be overmolded around the chip and a portion of the leads. The leads may then extend external to the housing for mounting to an external part, such as a printed circuit board (PCB). However, this known package approach requires use of a molding process to form the housing around the chip. Moreover, the chip is relatively thermally isolated within the housing so that heat dissipation from the chip may not be ideal during operation.

### Brief Summary

A semiconductor package for a surface mounted device is provided. The semiconductor package may include a metallic housing that has a main portion having a closed side and an open side, where a rim is disposed on the open side. The semiconductor package may further include a semiconductor die, disposed within the housing, wherein a first main surface of the semiconductor die is electrically coupled to the closed side of the metallic housing. The semiconductor package may also include an outer insert, disposed opposite the second main surface of the semiconductor die, wherein the outer insert and the rim are arranged in a coplanar fashion.

The semiconductor die may have an overvoltage protection device.

### Brief Description of the Drawings

**FIG. 1A** illustrates a bottom plan view of a semiconductor package, according to the present disclosure;
**FIG. 1B** illustrates a side sectional view of the semiconductor package of FIG. 1A;
**FIG. 1C** illustrates an end sectional view of the semiconductor package of FIG. 1A;
**FIG. 1D** illustrates a top isometric view of the semiconductor package of FIG. 1A;
**FIG. 1E** illustrates a bottom isometric view of the semiconductor package of FIG. 1A;
**FIG. 1F** illustrates an end sectional view of the semiconductor package of FIG. 1A, in a configuration attached to a substrate;
**FIG. 2A** illustrates a bottom plan view of another semiconductor package, according to the present disclosure;
**FIG. 2B** illustrates a side sectional view of the semiconductor package of FIG. 2A;
**FIG. 2C** illustrates an end sectional view of the semiconductor package of FIG. 2A;
**FIG. 3A** illustrates a bottom plan view of a semiconductor package, according to the present disclosure;
**FIG. 3B** illustrates a side sectional view of the semiconductor package of FIG. 3A;
**FIG. 3C** illustrates an end sectional view of the semiconductor package of FIG. 3A;
**FIG. 4A** illustrates a bottom plan view of a semiconductor package, according to the present disclosure;
**FIG. 4B** illustrates a side sectional view of the semiconductor package of FIG. 4A;
**FIG. 4C** illustrates an end sectional view of the semiconductor package of FIG. 4A;
**FIG. 5A** illustrates a bottom plan view of a semiconductor package, according to the present disclosure;
**FIG. 5B** illustrates a side sectional view of the semiconductor package of FIG. 5A;
**FIG. 5C** illustrates an end sectional view of the semiconductor package of FIG. 5A;
**FIG. 6A** illustrates a bottom plan view of a semiconductor package, according to the present disclosure;
**FIG. 6B** illustrates a side sectional view of the semiconductor package of FIG. 6A; and
**FIG. 6C** illustrates an end sectional view of the semiconductor package of FIG. 6A.

### Description

The disclosure will now be described more fully hereinafter with reference to the accompanying drawings.

In the following description and/or claims, the terms "on," "overlying," "disposed on" and "over" may be used in the following description and claims. "On," "overlying," "disposed on" and "over" may be used to indicate that two or more elements are in direct physical contact with one another. Also, the term "on,", "overlying," "disposed on," and "over", may mean that two or more elements are not in direct contact with one another. For example, "over" may mean that one element is above another element while not contacting one another and may have another element or elements in between the two elements. Furthermore, the term "and/or" may mean "and", it may mean "or", it may mean "exclusive-or", it may mean "one", it may mean "some, but not all", it may mean "neither", and/or it may mean "both", although the scope of claimed subject matter is not limited in this respect.

A novel semiconductor device package and method of assembly are provided. As detailed below, a semiconductor device package includes a novel combination of a package housing and inserts for use in SMD device technology, for example. As used herein SMD may refer to surface mounted devices for applications such as mounting on suitable substrate, such as a printed circuit board (PCB).

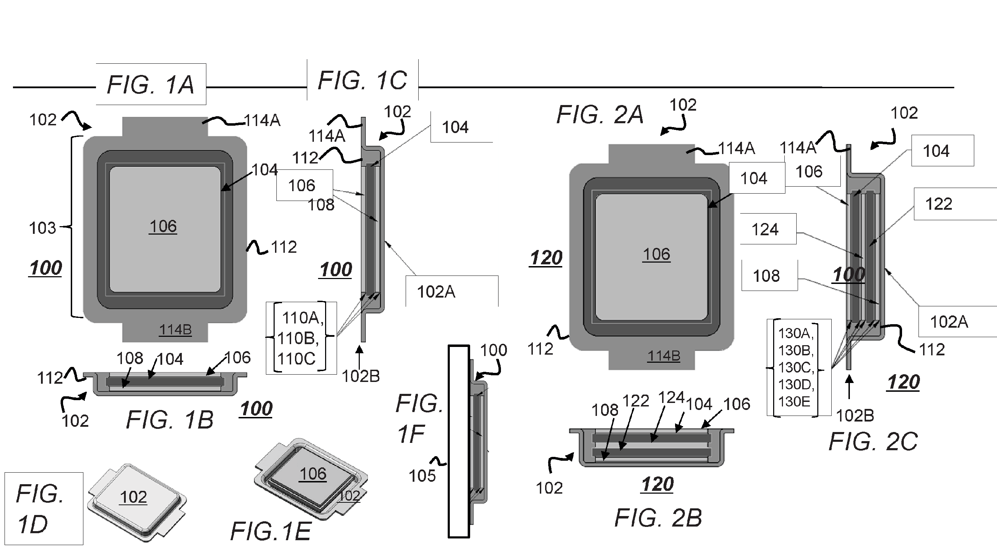

**FIG. 1A** illustrates a bottom plan view of a semiconductor package 100, according to the present disclosure. The semiconductor package 100 may be for use in SMD devices, such as applications where the semiconductor package 100 is attached to a substrate such as a PCB. The semiconductor package 100 may include a metallic housing, shown as housing 102. The housing 102 may in particular be an electrical conductor and a high thermal conductor. The housing 102 may include a main portion 103, having a closed side 102A, and an open side 102B, wherein a rim 112 is disposed on or around the open side 102B. As such, the main portion 103 of housing 102 defines a cavity or recess to accommodate various components, as best shown in FIG. 1B, FIG. 1C, FIG. 1E, and FIG. 1F in particular.

The housing 102 may include a first tab 114A, extending from the rim 112 along a first edge of the main portion 103 of the housing 102,and may also includer a second tab 114B, extending from the rim 112 along a second edge of the main portion 103 of the housing 102. These tabs may act as lead structures for attaching to an external electrical circuit.

The semiconductor package 100 may also include a semiconductor die 104, disposed within the housing 102, wherein a first main surface of the semiconductor die 104 is electrically coupled to the closed side 102A of the housing 102. The semiconductor die 104 may be a transient voltage suppression (TVS) diode or a Sidactor ^{®} (Sidactor is a trademark of Littelfuse, Inc.). The semiconductor package 100 may also include an outer insert 106 that is disposed opposite a second main surface of the semiconductor die 104, where the outer insert 106 and the rim 112 are arranged in a coplanar fashion, as best shown in FIG. 1B and FIG. 1C. Thus, the semiconductor package 100 may be conveniently mounted on a substrate 105, as shown in FIG. 1F. In the particular embodiment of FIG. 1A-FIG. 1F, the first tab 114A and the second tab 114B are arranged in coplanar fashion with the outer insert 106, as best illustrated in FIG. 1C and FIG. 1F. Thus, these tabs act as leads that may conveniently couple to electrical connections on a substrate 105 when the semiconductor package 100 is mounted thereon. Moreover, because the first tab 114A and the second tab 114B are arranged in coplanar fashion with the outer insert 106, these structures may readily attach the same surface of the substrate 105.

In FIG. 1A-FIG. 1F the semiconductor package 100 further includes an inner insert 108, disposed between the first main surface of the semiconductor die 104 and the closed side 102A of the housing 102. The inserts, such as inner insert 108 and outer insert 106 may be a suitable metal material in the form of a sheet or a slug, such as a copper slug. The inserts may act both as electrical conductors and thermal conductors. Thus, for example, the inner insert 108 may be a copper slug that connects a first terminal of the semiconductor die 104 on the first main surface (the surface facing the closed side 102A) to the housing 102. The inner insert 108 may serve as a good thermal conductor to conduct heat away from the semiconductor die 104 during operation, where the heat may be more readily dissipated through housing 102 to the external ambient. Similarly, the outer insert 106 may be a copper slug that connects a second terminal of the semiconductor die 104 on the second main surface (the surface facing the open side 102B) to an external circuit in a substrate 105. The outer insert 106 may also serve as a good thermal conductor to conduct heat away from the semiconductor die 104 during operation, where the heat may be more readily dissipated into a substrate 105.

The thickness of the outer insert 106 and/or the thickness of the inner insert 108 may be adjusted according to the thickness of the semiconductor die 104 in order that the outer surface of the outer insert 106 remains coplanar with the first tab 114A and the second tab 114B. Thus, for example, for two different packages where the thickness of a semiconductor die in a first package is thicker than a semiconductor die in a second package, the thickness of an outer insert in the first package may be less than the thickness of an outer insert in the second package.

The components inside housing 102 may be mechanically and electrically coupled to one another using a suitable set of joining layers, such as solder layers. These layers are shown as layer 110A, joining outer insert 106 to semiconductor die 104, layer 110B, joining semiconductor die 104 to inner insert 108, and layer 110C, joining inner insert 108 to the closed side 102A of housing 102. Each of these layers may be formed by providing a solder material for example on a relevant surface, and treating the solder by heating.

**FIG. 2A** illustrates a bottom plan view of a semiconductor package 120, according to the present disclosure. The semiconductor package 120 may be for use in SMD devices, such as applications where the semiconductor package 100 is attached to a substrate such as a PCB. The semiconductor package 120 may include similar components to those components in semiconductor package 100, where like components are labeled the same, and may serve a same function. The semiconductor package 120 may include additional components, including a second semiconductor die, shown as semiconductor die 122, disposed between the first semiconductor die, meaning the semiconductor die 104, and the inner insert 108, and a middle insert 124, disposed between the semiconductor die 104 and the semiconductor die 122. As best illustrated in FIG. 2B and FIG. 2C, a series of interface layers, such as solder, may also be included to join the various components of the semiconductor package to one another, providing electrical coupling, as well as good thermal coupling, between the components. These layers are shown as layer 130A, joining outer insert 106 to semiconductor die 104; layer 130B, joining semiconductor die 104 to middle insert 124; layer 130C, joining middle insert 124 to semiconductor die 122; layer 130D, joining inner insert 108 to semiconductor die 122, and layer 130E, joining inner insert 108 to the closed side 102A of housing 102.

In FIGs. 2A-2C, two semiconductor die are incorporated in the housing 102. In one example, where the semiconductor die 104 and semiconductor die 122 each form a TVS diode device, the two TVS diodes may be arranged in a cathode-to-anode fashion, for example, so that the breakdown voltage is increased according to a sum of the individual breakdown voltage of the two different semiconductor die. A semiconductor package including the housing 102 or similar housing, to be described, may include three or more stacked semiconductor die.

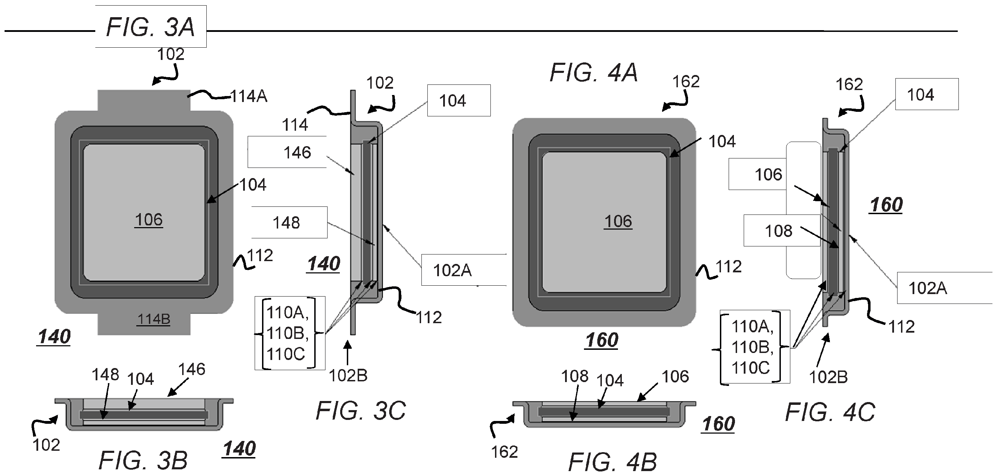

A semiconductor die may be arranged in a housing with multiple inserts, where the thickness of one insert varies from the thickness of at least one other insert. FIG. 3A-FIG. 3C detail one such, shown as semiconductor package 140, where just one semiconductor die is sandwiched between two inserts, similar to the configuration of FIG. 1A-FIG. 1F. A difference between the semiconductor package 100 and the semiconductor package 140 is that an outer insert 146 is provided, having a greater thickness than the thickness of an inner insert 108. This arrangement may be useful to adjust the thermal conduction, heat capacity to absorb heat generated, and/or electrical conduction between the semiconductor die 104 and an external substrate, one the one hand, and the electrical/thermal conduction between the semiconductor die 104 and housing 102, on the other hand. However, in other embodiments, an inner insert may be used that has greater thickness than the outer insert, according to a targeted operation of the package.

A housing is provided with a pair of tabs that may act as leads for coupling to electrical circuitry in an external component, such as a PCB. However, the tabs may be omitted, where the rim 112 may be sufficient to form external electrical connections. FIG. 4A-FIG. 4C details one such, shown as semiconductor package 160, where a housing 162 is provided that is similar to housing 102 but differs, in that no tabs are provided along the rim 112. This housing may have the advantage of being relatively easier to fabricate as compared to housing 102.

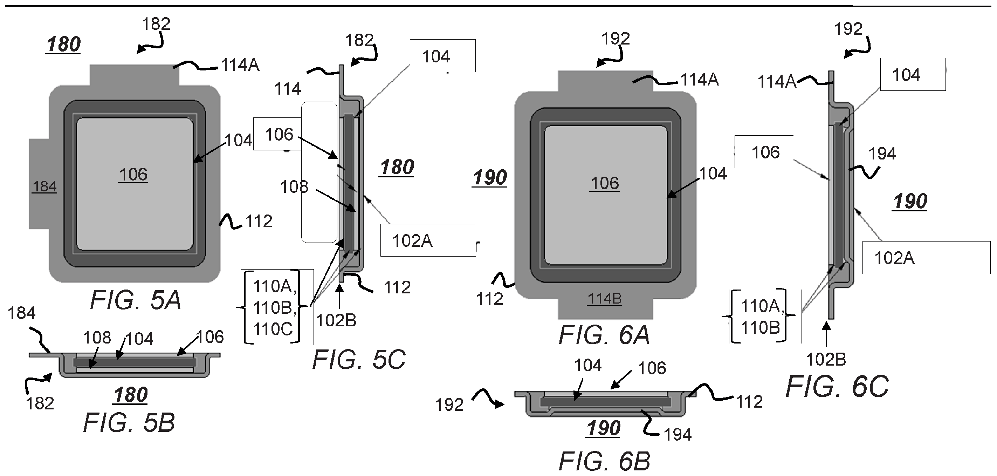

In FIG. 1A, FIG. 2A, and FIG. 3A, a housing is provided with a pair of tabs that are arranged along opposite edges of the rim 112. In FIG. 5A-FIG. 5C , shown as semiconductor package 180 where a housing 182 includes pair of tabs, shown as first tab 114A and second tab 184 that are arranged along adjacent edges of the rim 112. This configuration may be useful to couple to the specific configuration of circuitry in a substrate where the housing 182 is to be mounted. The different aforementioned thus provide flexibility in design, and in particular, according to the different configuration of circuitry that may be present in different substrates, according to different applications.

A Semiconductor package may be provided that include an inner insert, adjacent to the closed side of the housing. However, the inner insert may be omitted, where a semiconductor die is arranged adjacent to the closed side. FIG. 6A-FIG. 6C detail one such, shown as semiconductor package 190, where a housing 192 is provided that is similar to housing 102 but differs, in that the closed side 102A is provided with a coining structure 194, where no inner insert is included. The housing 192 may have the overall size and general shape of the housing 102, but may be coined on the closed side 102A, so the housing 192 can be brought into close contact with the semiconductor die 104 without using an inner insert. This approach saves the cost of having to use an inner insert to couple a semiconductor chip to the metallic housing.

In variants, a housing may be provided with a sealant in the cavity formed by the main portion of the housing, where the sealant is disposed generally between a semiconductor die and the housing, to ensure that electrical isolation of different terminals is maintained for the device formed in the semiconductor die. The sealant may be an epoxy sealant.

## Claims

1. A semiconductor package for a surface mounted device, comprising:
a metallic housing, comprising a main portion having a closed side and an open side, wherein a rim is disposed on the open side;
a semiconductor die, disposed within the housing, wherein a first main surface of the semiconductor die is electrically coupled to the closed side of the metallic housing; and
an outer insert, disposed opposite a second main surface of the semiconductor die, wherein the outer insert and the rim are arranged in a coplanar fashion.

2. The semiconductor package of claim 1, further comprising:
an inner insert, disposed between the first main surface of the semiconductor die and the closed side of the metallic housing.

3. The semiconductor package of claim 2, wherein the semiconductor die is a first semiconductor die, the semiconductor package further comprising:
a second semiconductor die, disposed between the first semiconductor die and the inner insert; and
a middle insert, disposed between the first semiconductor die and the second semiconductor die.

4. The semiconductor package of any of the preceding claims wherein the outer insert comprises a first thickness, and the inner insert comprises a second thickness, less than the first thickness.

5. The semiconductor package of any of the preceding claims the metallic housing further comprising:
a first tab, extending from the rim along a first edge of the main portion of the housing; and
a second tab, extending from the rim along a second edge of the main portion of the housing, wherein the first tab and the second tab are arranged in coplanar fashion with the outer insert.

6. The semiconductor package of claim 5, wherein the first edge is adjacent to the second edge.

7. The semiconductor package of any of the preceding claims, wherein the closed side of the metallic housing has a coining structure, wherein a layer of solder is disposed between the semiconductor die and the closed side.

8. The semiconductor package of any of the preceding claims, wherein the outer insert comprises a copper slug.

9. The semiconductor package of any of the preceding claims wherein the semiconductor die comprises a TVS diode, having a first main terminal that extends over the first main surface and a second main terminal that extends over the second main surface.

10. The semiconductor package of any of the preceding claims further comprising a sealant, disposed between the semiconductor die and the metallic housing.

11. The semiconductor package of any of the preceding claims,
wherein the semiconductor die comprises an overvoltage protection device.

12. The semiconductor package of claim 11, wherein the overvoltage protection device is a transient voltage suppression device or a Sidactor device.

13. The semiconductor package of any of the preceding claims 2-12, further comprising:
a first solder layer, disposed between the inner insert and the closed side of the metallic housing;
a second solder layer, disposed between the inner insert and the semiconductor die; and
a third solder layer, disposed between the semiconductor die and the outer insert.

14. A surface mounted device comprising a semiconductor package according to any of the preceding claims.

15. Use of a semiconductor device according to any of the preceding claims in a surface mounted device.
